# EUROPEAN PATENT SPECIFICATION

(11) **EP 1 051 891 B1**
(45) Date of publication and mention of the grant of the patent: **22.05.2002**
(21) Application number: 99902935.8
(22) Date of filing: 03.02.1999
(51) Int. Cl.: H05K 9/00

(54) **METHOD OF FABRICATING A SUPPORT PROVIDED WITH SHIELDING AGAINST INTERFERING RADIATION, AND SHIELDING MATERIAL**
VERFAHREN ZUR HERSTELLUNG EINES TRÄGERS MIT EINER ABSCHIRMUNG GEGEN ELEKTROMAGNETISCHE STÖRFELDER UND MATERIAL DAFÜR
PROCEDE DE FABRICATION D'UN SUPPORT POURVU D'UN BLINDAGE CONTRE LES RAYONNEMENTS D'INTERFERENCES ET MATERIEL DE BLINDAGE

(30) Priority: 04.02.1998 NL 1008197
(43) Date of publication of application: 15.11.2000
(73) Proprietor: STORK SCREENS B.V., 5831 AT Boxmeer (NL)
(72) Inventor: BERGSHOEFF, Pieter, Dick, NL-6605 RA Wijchen (NL); MACHIELSE, Jacob, Joost, NL-5975 SE Sevenum (NL); BLANKENBORG, Stephanus, Gerardus, Johannes, NL-6511 ZD Nijmegen (NL)
(74) Representative: Volmer, Johannes Cornelis
(86) International application number: NL9900056
(87) International publication number: WO9940770

(56) References cited:
- EP-A- 0 597 670
- WO-A-95/34423
- DE-A- 19 611 137
- GB-A- 766 257
- US-A- 4 403 004
- PATENT ABSTRACTS OF JAPAN vol. 011, no. 034 (M-558), 31 January 1987 & JP 61 205110 A (DAINIPPON PRINTING CO LTD), 11 September 1986
- PATENT ABSTRACTS OF JAPAN vol. 014, no. 163 (E-0910), 29 March 1990 & JP 02 018996 A (MISHIMA KOSAN CO LTD;OTHERS: 01), 23 January 1990

## Description

The present invention relates to a method of fabricating a support provided with shielding against interfering radiation, said method comprising the steps of a metallized plastic substrate being placed into an injection mould, and a plastic being injection-moulded in the mould to form the support.

Such a method is known from Research Disclosure, No. 27302, January 1987. This describes a technique where a plastic film or plastic plate which is compatible with the casting material for the support to be formed is metallized and is made conductive on one side or both sides by means of a number of methods known per se in the art. The metallized film is then subjected to a preshaping operation and then placed into the mould or is deformed in the mould itself. Then the mould is closed, and molten resin is injected into the mould to form the support. According to this publication, the metal of the metallized plastic substrate generally consists of copper, because of the good conductivity of copper, on which a thin deposit of nickel has been formed. If desired, an adhesive layer for paint can be applied.

Such a shielding is used either to protect electronic devices against external interfering radiation or to protect the environment from radiation which is generated by the electronic device itself, with which the support provided with shielding is used.

Electronic devices which can be sensitive to interfering radiation, such as electromagnetic radiation, are electronic regulating, control or switching devices, and also communication- and data-processing devices. Examples of such devices include microdata processors, computers, integrated circuits, microswitches, mobile telephones, transmitting and receiving equipment, paging equipment, television, etc.

Such protecting of electronic devices is also referred to as shielding. The requirements regarding shielding, which the abovementioned devices are to meet, are becoming evermore stringent and are evermore often administered on an international level.

Suitable shielding materials mostly consist of electrically and/or magnetically readily conductive materials and therefore often of metal. Examples of such shielding are metal enclosures or plastic enclosures which are provided with a thin metal layer. Apart from the abovementioned shielding technique, such a metal layer can also be applied, for example, in the form of a metal paint, a metal layer applied by electroless plating or electroplating, a metal layer formed with the aid of vapour deposition or sputtering, etc. Many of these techniques, however, are complicated and consequently expensive. The usually complex structure of the housing that is to be shielded likewise makes it difficult to provide such a housing with effective shielding.

One of the techniques that can be carried out considerably more simply and inexpensively, is the so-called "in mould-foiling", as set forth in the abovementioned article from Research Disclosure. This involves either a metallized foil being deformed in the mould, for example by deep-drawing, or a metallized foil deformed in advance being placed into the mould, the molten resin then being injected in order to coat the foil. The shielding materials mentioned in said article, i.e. copper and nickel, have the drawback, however, in that they are not readily suitable for this technique, because of their low elongation. Deep-drawing first of all involves forming the corners, the material being subjected to flexural stress, whereupon the material is subjected to further stretching. If not enough material is present, cracks are formed which adversely affect the shielding efficiency.

A similar technique has been described in JP-A-61 205110. In this technique an electrically conductive sheet of an ultraplastic alloy having 45-40 wt.% Pb and 65-60 wt.% Sn is used, which sheet is provided on both sides thereof with a thermoplastic synthetic resin layer. The Pb/Sn-sheet is rolled until a thickness of 50-100 µm. Each of the resin layers is 0,3-0,6 mm thick. The assembled sheet thus obtained having a minimum thickness of 650 µm is placed into a mould and deformed in advance, whereafter the article is injection moulded.

A disadvantage of this known shielding, comprising a sandwich structure of a Pb/Sn-sheet incorporated between resin sheets is the relatively large thickness thereof. The maximum allowed thickness of support + shielding is approximately 1 mm for numerous applications, which means that at a total thickness of the shielding of 650 µm hardly any space is available for the material of the support, such as a housing, resulting in disadvantageous effects to the final product. Furthermore injection moulding of the support onto such a thick shielding is technically more difficult than onto a thinner shielding. Other drawbacks of this known shielding are that Pb is not an environment-friendly material, that a sandwich configuration is more difficult to recycle, and that the weight thereof is relatively high. Yet another significant drawback of all sandwich configurations is that it is difficult to produce a fully closed support system of a housing of a lid (compare cage of Faraday) because of the very small surfaces of the electrically conductive metal sheets of the housing and the lid respectively, which have to be in contact with each other in order to achieve a good shielding action.

There is therefore a need for shielding material which is suitable for the fabrication of a support provided with shielding against interfering radiation.

It is an object of the present invention to provide a method of fabricating a support provided with such shielding, the metallized plastic substrate used being readily deformed without the shielding characteristics being impaired, as well as to provide a shielding material having these advantageous characteristics, in particular for use with such a method.

According to the present invention, this object is achieved by the method as defined in claim 1.

Tin is a soft material and has high elongation. At elevated temperatures, at which the method is usually implemented, tin moreover begins to yield readily, so that the risk of cracking is reduced even further. Thus a support provided with excellent shielding against interfering radiation is obtained.

When tin is employed as shielding material, such as in the invention, a relatively thin metallized plastic substrate can be used, which will be shown hereinafter. This means that the support, i.e. the housing and the like, can be allowed to have a larger thickness than in JP-A-61 205110, which provides for a technically simple method as a whole.

Preferred methods are defined in the dependent claims.

Advantageously, the metallized plastic substrate comprises an interlayer of copper, which is situated between the tin layer and the plastic substrate. Copper, which in itself exhibits little elongation, can be applied on the plastic layer in a very thin layer, for example by means of sputtering and other customary techniques. The tin layer can be applied subsequently in the desired thickness by means of plating. The copper interlayer has excellent adhesion to the plastic substrate and additionally has a higher conductivity than tin, which is favourable for the shielding effect. An additional advantage of this layer composition is that the copper, which is a better conductor but corrodes more rapidly, is protected by the tin layer.

Implementation of the method according to the invention involves tailoring the plastic of the metallized plastic substrate to the material of the support to be fabricated. Preferably, the plastic is selected from the group consisting of polycarbonate (PC), acrylonitrile-butadiene-styrene (ABS) and mixtures thereof. The plastic can further advantageously contain a filler, in order to improve the properties of the plastic or reduce its weight.

If desired, the tin layer of the metallized plastic substrate can additionally be protected against corrosion by a corrosion-resistant metal layer being applied on top of this layer. A suitable metal for the corrosion-resistant metal layer comprises nickel, although other corrosion-resistant metals can also be used.

As set forth in the abovementioned article from Research Disclosure, application of the metallized plastic substrate may comprise a three-dimensional deforming step. Because of the good elongation characteristics of tin, the metallized plastic substrate can readily be deformed three-dimensionally without cracks being formed. A preferred embodiment consists of the metallized plastic film being deep-drawn, in order to introduce the latter into the injection mould. This step is further carried out advantageously at elevated temperature, for example about 100°C. At this temperature, tin exhibits a certain degree of yielding behaviour, which is beneficial to the deforming operation.

In a particularly preferred embodiment of the method according to the invention a number of preshaped shieldings are manufactured from a flat metallized plastic substrate, which shieldings are then separated from each other. Such a preshaped shielding is placed into an injection mould, whereafter the support material is injection moulded onto the plastic of the shielding. Advantageously the metal side of the flat metallized plastic substrate is placed upon a predeform die in order to deform the substrate in advance, which die is provided with protuberances and/or recesses in accordance with the desired preshape of the shielding. In the case of a substrate of polycarbonate having a Sn-layer preferably the die is heated up to the range of 140-170°C, while the plastic backside of the substrate is heated up to the range of 200-230°C, advantageously by means of IR-irradiation. Under these circumstances the plastic substrate can be deep-drawn to the desired preshaped shielding by vacuum sucking. The shieldings are cut out and then placed into an injection mould in order to injection mould the support.

Known shielding systems often comprise a (boxlike) container, in which the device to be shielded is received, and a lid (mostly connected to the container by means of snap contructions), wherein the metal shieldings of the individual parts are electrically in contact with each other by means of an electrically conductive ring of silicone. The necessity of the electrical contact between the individual parts is described, e.g. in WO 95/34423. Such a ring or gasket is expensive and time-consuming as a result of the complicated fabrication.

In a particular embodiment of the support, especially a boxlike support, which is manufactured according to the invention, the plastic substrate metallized with Sn, such as a PC-foil having a tin layer, is allowed to extend beyond the peripheral edges of the injection moulded support, afterwards the extending parts of the shielding being coiled or folded. In this way these coiled or folded parts provide for a large contact surface for another additional part which is to be placed thereupon, such as a lid, which has also been provided with a shielding according to the invention. However, it will be appreciated that this structure of a support, consisting of parts to be connected to each other, can also be used with other shielding materials than Sn only.

Other moulding methods such as "thermoforming" are likewise suitable.

The layer thickness of the tin layer is advantageously 1-20 µm, preferably 3-5 µm. The layer thickness of the plastic layer of the metallized plastic substrate is advantageously 10-250 µm, preferably about 75 µm. The layer thickness of the copper interlayer, if present, is advantageously 0.025-1 µm, preferably about 0.050 µm. The support preferably is a plastic housing, as customarily used in mobile telephones, television sets, computer equipment and other devices mentioned earlier. Advantageously, the method according to the invention involves the housing being applied to the plastic layer of the metallized plastic substrate, so that the shielding material is situated on the inside of the housing.

The invention also relates to a shielding material, in particular for use with the method according to the invention, the shielding material comprising a plastic substrate provided with a tin layer. In the first place the shielding material according to the invention is suitable for methods in which the screening material is first deformed, whereafter the support is applied to the deformed shielding material, as with the above-discussed methods according to the invention, in particular in the case of supports having a complex structure. The shielding material, however, is also eminently suitable for being applied to prefabricated supports, as in the case of supports having a simple configuration.

As already explained hereinabove, provision may be made for a copper film between the plastic film and the tin layer. If desired, provision can be made for a corrosion-resistant metal layer, such as a layer of nickel, on top of the tin layer. The choice of material and the layer thicknesses which are preferred are identical to the abovementioned materials and values.

The invention is illustrated below with reference to a few examples.

### Example 1

This example describes the fabrication of a metallized plastic substrate, which involves various metals being applied to a plastic film.

Onto a plastic film, which had been prepared from lexane (PC), having a thickness of 75 µm, various metals were deposited with the aid of electrolysis, in the thicknesses specified in Table 1. A copper interlayer having a thickness of 50 nm had been applied to the plastic film, in order to form a conductive layer. This conductive layer is necessary for the deposition of the metal from a plating bath.

Table 1 below also shows the results of the measurements of the so-called "shielding effectiveness", which was measured according to ASTM D4935-89, which involved shielding material to be tested being positioned between a transmitter and a receiver and the effectiveness of the shielding being measured at various frequencies. For purposes of comparison, the data are also given of a plastic film on its own and those of an aluminium disc. The latter is known to have an excellent shielding action.

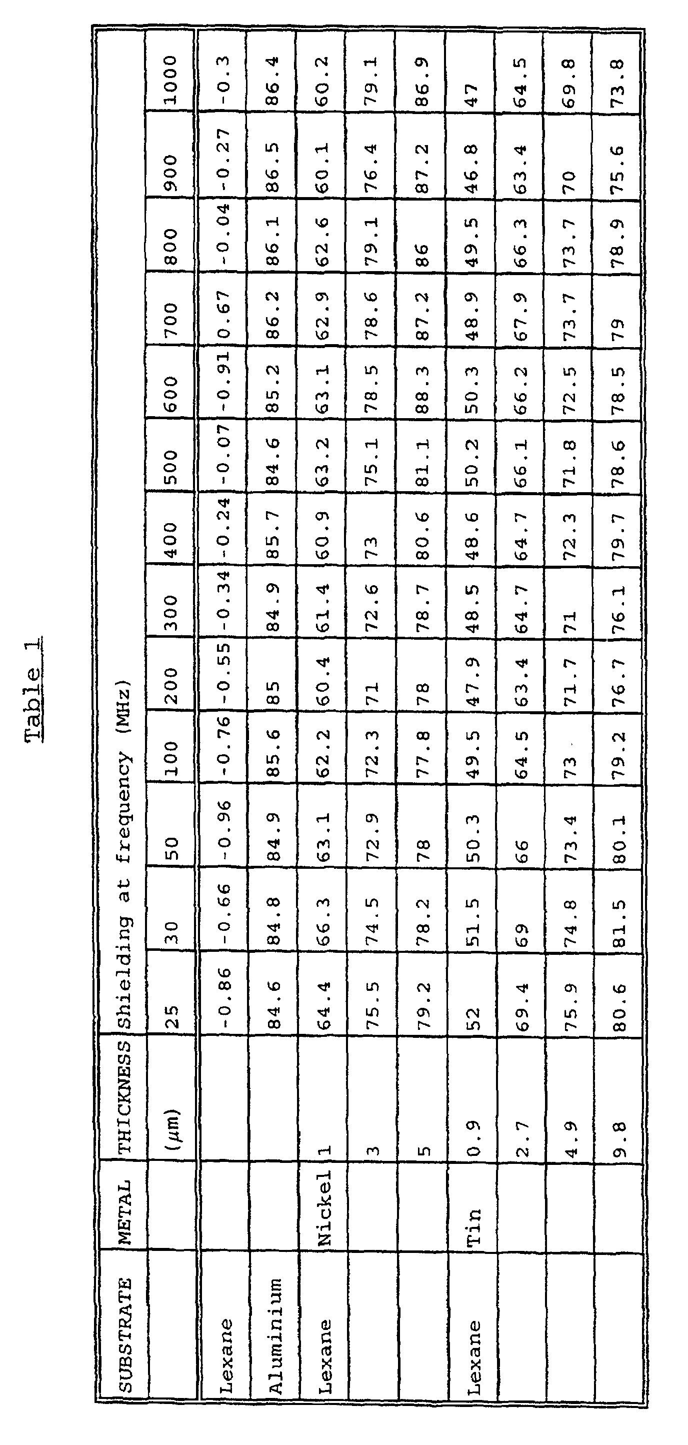

The results shown in this table demonstrate that the shielding action of tin at the measured frequencies is comparable with that of nickel, although a slightly greater layer thickness appears to be required. The reported values, however, are not absolute numbers, but merely provide an indication of the shielding action of the various shielding materials used.

### Example 2

Table 2 below gives the results of the resistance measurement of tin- and copper-coated lexane having a thickness of 75 µm. These resistance measurements were carried out with three different thicknesses of the tin layer, 0.9, 4.5 and 9.3 µm, respectively. The strips to be stretched which were used had a length of 16 cm and a width of 2 cm. The tests were carried out at room temperature.

**Table 2**

| Elongation (%) | Resistance (ohms) | | |
|---|---|---|---|
| | 0.9 µm | 4.5 µm | 9.3 µm |
| 0 | 2 | 0.7 | 0.5 |
| 15 | 2.5 | 0.7 | 0.5 |
| 25 | 4.7 | 0.8 | 0.5 |
| 40 | 9 | 0.9 | 0.6 |
| 50 | 8 | 0.9 | 0.6 |

The table shows that at a thickness of the tin layer of 4.5 µm and 9.3 µm the resistance at increasing elongation remains virtually constant, which indicates that the tin layer remains continuous, and virtually no small cracks are formed.

Tests were also carried out with plastic films onto which nickel, copper and tin, respectively had been deposited in the thicknesses shown in Table 3. These materials were subjected to stretching tests at a temperature of 150°C, at which the resistance was measured. This table shows that electroformed nickel has a low elongation at break, namely about 8%. Copper has higher elongation, but the resistance increases with increasing elongation, which suggests cracking in the copper layer. Tin, in contrast, has much better elongation characteristics, so that the resistance remains low even at very large elongations. This indicates excellent formability.

**Table 3**

| METAL | THICKNESS (µm) | ELONGATION (%) | RESISTANCE (ohms) |
|---|---|---|---|
| NICKEL | 1 | 0 | 0.5 |
| | 1 | 8 | INFINITE |
| COPPER | 1 | 0 | 0.4 |
| | 1 | 6 | 0.6 |
| | 1 | 22 | 0.7 |
| | 1 | 48 | 1.7 |
| | 1 | 94 | 5.7 |
| TIN | 5 | 0 | 0.5 |
| | 5 | 44 | 0.9 |
| | 5 | 98 | 1.9 |
| | 5 | 148 | 3.5 |
| | 5 | 174 | 7.2 |
| TIN | 10 | 0 | 0.4 |
| | 10 | 43 | 0.5 |
| | 10 | 98 | 1 |
| | 10 | 116 | 1.5 |
| | 10 | 146 | 1.5 |
| | 10 | 170 | 2.4 |
| | 10 | 192 | 3.3 |

Tests under flexural strain yield comparable results and differences.

## Claims

1. Method of fabricating a support provided with shielding against interfering radiation, said method comprising the steps of a metallized plastic substrate being placed into an injection mould, and a plastic being injection-moulded in the mould to form the support, **characterized in that** the metallized plastic substrate comprises a tin layer.

2. Method according to claim 1, **characterized in that** the metallized plastic substrate comprises an interlayer of copper.

3. Method according to claim 1 or 2, **characterized in that** the plastic of the metallized plastic substrate is selected from the group consisting of polycarbonate (PC), acrylonitrile-butadiene-styrene (ABS) and mixtures thereof.

4. Method according to any one of the preceding claims, **characterized in that** the plastic of the metallized plastic substrate contains a filler.

5. Method according to any one of the preceding claims, **characterized in that** the tin layer of the metallized plastic substrate has a corrosion-resistant metal layer applied on top of it.

6. Method according to claim 5, **characterized in that** the metal of the corrosion-resistant metal layer comprises nickel.

7. Method according to any one of the preceding claims, **characterized in that** placing of the metallized plastic substrate comprises a three-dimensional deforming step.

8. Method according to claim 7, **characterized in that** the metallized plastic substrate is subjected to deep-drawing.

9. Method according to claim 8, **characterized in that** said deep-drawing is carried out at a temperature of about 100°C.

10. Method according to any one of the preceding claims 1-6, **characterized in that** the metallized plastic substrate is deformed in advance, before the substrate is placed into the injection mould.

11. Method according to claim 10, **characterized in that** the metal of the metallized plastic substrate is brought into contact with a heated predeform die, and also the plastic layer of the metallized plastic substrate is heated.

12. Method according to any one of the preceding claims, **characterized in that** the layer thickness of the tin layer is 1-20 micrometer.

13. Method according to any one of the preceding claims, **characterized in that** the layer thickness of the plastic layer of the metallized plastic substrate is 10-250 micrometer.

14. Method according to any one of the preceding claims, **characterized in that** the layer thickness of the copper layer is 0.025-1 micrometer.

15. Method according to any one of the preceding claims, **characterized in that** the support comprises a plastic housing.

16. Method according to claim 15, **characterized in that** the housing is applied to the plastic layer of the metallized plastic substrate.

17. Method according to any one of the preceding claims, **characterized in that** the metallized plastic substrate is allowed to extend beyond the peripheral edge of the injection moulded support, and the extending parts are shaped into a contact section having a large surface.

18. Screening material, obviously intended for use in the method according to any one of the preceding claims 1-17, consisting of a metallized plastic substrate, wherein the metallized plastic substrate comprises a tin layer, and wherein the layer thickness of a plastic layer of the metallized plastic substrate is 10-250 micrometer.

19. Screening material according to claim 18, **characterized in that** a copper film is provided between the plastic layer and the tin layer.

20. Screening material according to claim 18 or 19, **characterized in that** a corrosion-resistant metal layer is provided on top of the tin layer.

## Patentansprüche

1. Verfahren zum Herstellen eines Trägers, der mit Abschirmung gegen störende Strahlung versehen ist, wobei das Verfahren die Schritte des Einlegens eines metallisierten Kunststoffsubstrats in eine Spritzgießform und des Spritzgießens eines Kunststoffs in die Form zum Herstellen des Trägers umfasst, **dadurch gekennzeichnet, dass** das metallisierte Kunststoffsubstrat eine Zinnschicht umfasst.

2. Verfahren nach Anspruch 1, **dadurch gekennzeichnet, dass** das metallisierte Kunststoffsubstrat eine Zwischenschicht aus Kupfer umfasst.

3. Verfahren nach Anspruch 1 oder 2, **dadurch gekennzeichnet, dass** der Kunststoff des metallisierten Kunststoffsubstrats aus der Gruppe ausgewählt wird, die aus Polycarbonat (PC), Acrylnitril-Butadien-Styrol (ABS) und Gemischen daraus besteht.

4. Verfahren nach einem der vorangehenden Ansprüche, **dadurch gekennzeichnet, dass** der Kunststoff des metallisierten Kunststoffsubstrats einen Füllstoff enthält.

5. Verfahren nach einem der vorangehenden Ansprüche, **dadurch gekennzeichnet, dass** auf die Zinnschicht des metallisierten Kunststoffsubstrats eine korrosionsbeständige Metallschicht aufgetragen wird.

6. Verfahren nach Anspruch 5, **dadurch gekennzeichnet, dass** das Metall der korrosionsbeständigen Metallschicht Nickel umfasst.

7. Verfahren nach einem der vorangehenden Ansprüche, **dadurch gekennzeichnet, dass** das Einlegen des metallisierten Kunststoffsubstrats einen dreidimensionalen Umformungsschritt umfasst.

8. Verfahren nach Anspruch 7, **dadurch gekennzeichnet, dass** das metallisierte Kunststoffsubstrat Tiefziehen unterzogen wird.

9. Verfahren nach Anspruch 8, **dadurch gekennzeichnet, dass** das Tiefziehen bei einer Temperatur von ungefähr 100°C ausgeführt wird.

10. Verfahren nach einem der vorangehenden Ansprüche 1-6, **dadurch gekennzeichnet, dass** das metallisierte Kunststoffsubstrat im Voraus umgeformt wird, bevor das Substrat in die Spritzgießform eingelegt wird.

11. Verfahren nach Anspruch 10, **dadurch gekennzeichnet, dass** das Metall des metallisierten Kunststoffsubstrats mit einer beheizten Vorumformungsform in Kontakt gebracht wird und auch die Kunststoffschicht des metallisierten Kunststoffsubstrats erhitzt wird.

12. Verfahren nach einem der vorangehenden Ansprüche, **dadurch gekennzeichnet, dass** die Schichtdicke der Zinnschicht 1-20 µm beträgt.

13. Verfahren nach einem der vorangehenden Ansprüche, **dadurch gekennzeichnet, dass** die Schichtdicke der Kunststoffschicht des metallisierten Kunststoffsubstrats 10-250 µm beträgt.

14. Verfahren nach einem der vorangehenden Ansprüche, **dadurch gekennzeichnet, dass** die Schichtdicke der Kupferschicht 0,025-1 µm beträgt.

15. Verfahren nach einem der vorangehenden Ansprüche, **dadurch gekennzeichnet, dass** der Träger ein Kunststoffgehäuse umfasst.

16. Verfahren nach Anspruch 15, **dadurch gekennzeichnet, dass** das Gehäuse auf die Kunststoffschicht des metallisierten Kunststoffsubstrats aufgebracht wird.

17. Verfahren nach einem der vorangehenden Ansprüche, **dadurch gekennzeichnet, dass** das metallisierte Kunststoffsubstrat sich über den Umfangsrand des spritzgegossenen Trägers hinaus erstrecken kann, und dass die sich darüber hinaus erstreckenden Teile zu einem Kontaktabschnitt mit großer Fläche geformt wird.

18. Abschirmungsmateriaf, das offensichtlich für den Einsatz in dem Verfahren nach einem der vorangehenden Ansprüche 1-17 bestimmt ist und aus einem metallisierten Kunststoffsubstrat besteht, wobei das metallisierte Kunststoffsubstrat eine Zinnschicht umfasst, und wobei die Schichtdicke einer Kunststoffschicht des metallisierten Kunststoffsubstrats 10-250 µm beträgt.

19. Abschirmungsmateial nach Anspruch 18, **dadurch gekennzeichnet, dass** ein Kupferfilm zwischen der Kunststoffschicht und der Zinnschicht vorhanden ist.

20. Abschirmungsmaterial nach Anspruch 18 oder 19, **dadurch gekennzeichnet, dass** eine korrosionsbeständige Metallschicht auf der Zinnschicht vorhanden ist.

## Revendications

1. Procédé de fabrication d'un support pourvu d'un blindage contre un rayonnement parasite, ledit procédé comprenant les étapes consistant à placer un substrat en plastique métallisé dans un moule d'injection et à mouler par injection un plastique dans le moule afin de former le support, **caractérisé en ce que** le substrat en plastique métallisé comprend une couche d'étain.

2. Procédé selon la revendication 1, **caractérisé en ce que** le substrat en plastique métallisé comprend une couche intermédiaire de cuivre.

3. Procédé selon la revendication 1 ou 2, **caractérisé en ce que** le plastique du substrat en plastique métallisé est sélectionné parmi le groupe composé de polycarbonate (PC), acrylonitrile-butadiène-styrène (ABS) et des mélanges de ceux-ci.

4. Procédé selon l'une quelconque des revendications précédentes, **caractérisé en ce que** le plastique du substrat en plastique métallisé contient un agent de remplissage.

5. Procédé selon l'une quelconque des revendications précédentes, **caractérisé en ce qu'**une couche métallique résistant à la corrosion est appliquée sur la couche d'étain du substrat en plastique métallisé.

6. Procédé selon la revendication 5, **caractérisé en ce que** le métal de la couche métallique résistant à la corrosion comprend du nickel.

7. Procédé selon l'une quelconque des revendications précédentes, **caractérisé en ce que** le positionnement du substrat en plastique métallisé comprend une étape de déformation tridimensionnelle.

8. Procédé selon la revendication 7, **caractérisé en ce que** le substrat en plastique métallisé est soumis à un emboutissage profond.

9. Procédé selon la revendication 8, **caractérisé en ce que** ledit emboutissage profond est effectué à une température d'environ 100°C.

10. Procédé selon l'une quelconque des revendications précédentes, **caractérisé en ce que** le substrat en plastique métallisé est déformé à l'avance, avant que le substrat ne soit placé dans le moule d'injection.

11. Procédé selon la revendication 10, **caractérisé en ce que** le métal du substrat en plastique métallisé est mis en contact avec une matrice de pré-déformation chauffée et, ainsi, la couche de plastique du substrat en plastique métallisé est chauffée.

12. Procédé selon l'une quelconque des revendications précédentes, **caractérisé en ce que** l'épaisseur de couche de la couche d'étain est comprise entre 1 et 20 µm.

13. Procédé selon l'une quelconque des revendications précédentes, **caractérisé en ce que** l'épaisseur de couche de la couche de plastique du substrat en plastique métallisé est comprise entre 10 et 250 µm.

14. Procédé selon l'une quelconque des revendications précédentes, **caractérisé en ce que** l'épaisseur de couche de la couche de cuivre est comprise entre 0,025 et 1 µm.

15. Procédé selon l'une quelconque des revendications précédentes, **caractérisé en ce que** le support comprend un logement en plastique.

16. Procédé selon la revendication 15, **caractérisé en ce que** le logement est appliqué à la couche en plastique du substrat en plastique métallisé.

17. Procédé selon l'une quelconque des revendications précédentes, **caractérisé en ce que** le substrat en plastique métallisé est autorisé à s'étendre au-delà du bord périphérique du support moulé par injection, et les parties qui s'étendent sont formées en une section de contact présentant une grande surface.

18. Matériau de blindage, manifestement destiné à être utilisé dans le procédé selon l'une quelconque des revendications précédentes 1 à 17, consistant en un substrat en plastique métallisé, dans lequel le substrat en plastique métallisé comprend une couche d'étain, et dans lequel l'épaisseur de couche d'une couche de plastique du substrat en plastique métallisé est comprise entre 10 et 250 µm.

19. Matériau de blindage selon la revendication 18, **caractérisé en ce qu'**un film de cuivre est prévu entre la couche de plastique et la couche d'étain.

20. Matériau de blindage selon la revendication 18 ou 19, **caractérisé en ce qu'**une couche métallique résistant à la corrosion est prévue sur la couche d'étain.
